# EUROPEAN PATENT SPECIFICATION

(11) **EP 0 808 023 B1**
(45) Date of publication and mention of the grant of the patent: **20.07.2005**
(21) Application number: 97401063.9
(22) Date of filing: 13.05.1997
(51) Int. Cl.: H03K 5/24

(54) **Current bit cell and switched current network formed of such cells**
Strombitzelle und stromgeschaltetes Netzwerk mit derartigen Zellen
Cellule de bit de courant et réseau à courant commuté formé de telles cellules

(30) Priority: 13.05.1996 FR 9605921
(43) Date of publication of application: 19.11.1997
(73) Proprietor: TEXAS INSTRUMENTS FRANCE, 06271 Villeneuve Loubet Cédex (FR); TEXAS INSTRUMENTS INCORPORATED, Dallas, Texas 75243 (US)
(72) Inventor: Carbou, Pierre, Torrettes sur Lou, 06140 (FR); Guignon, Pascal, Callian Fayence, 83440 (FR)
(74) Representative: Jacobson, Claude

(56) References cited:
- EP-A- 0 136 229
- US-A- 5 361 233
- IBM TECHNICAL DISCLOSURE BULLETIN, vol. 34, no. 10A, 1 March 1992, NEW YORK,US, pages 184-185, XP000302269 "COMBINED SENSE DECODER AND AMPLIFIER"

## Description

The present invention relates to the structure of a current bit cell intended to be used in switched current networks as, for example, in the implementation of analogue/digital converters ADCs.

The benefit of this structure resides in its capacity to produce networks of current bit cells with high density, a single type of device, and a decoding scheme allowing techniques to be applied which ensure the production of a monotonic device which minimises the matching errors.

Another advantage of this structure is the symmetry of its topology, which makes it suitable for the implementation of differential networks whose characteristics, connected with the unsusceptibility to noise, are attractive for the implementation of analogue circuits.

One known means of ensuring monotonicity, for example in a digital/analogue converter, is to add an element to each increment of a digital code.

Furthermore, it is also well known that the use of a "centroid" topology allows first-order minimisation of the errors resulting from matching gradients in integrated-circuit technology.

The use of the two techniques mentioned above requires a highly complex decoding scheme for each individual current bit cell.

It furthermore requires the use of N-type and P-type transistors, which means that the packing density of the cell cannot be optimised because of the need for two different types of substrate.

It furthermore has an asymmetric decoding structure which makes the cell inappropriate for differential networks.

Document EP-A-0136229 discloses a sense amplifier which selects one of a plurality of pairs of complementary input signals and generates an output signal corresponding to a selected pair of complementary input signals.

However, such a sense amplifier does not provide differential networks implementation.

Document IBM Technical Disclosure Bulletin vol. 34, 10.10A, March 1, 1992, New York, US, pages 184-185, "combined sense decoder and amplifier" discloses differential sense amplifiers which do not present symmetry of this topology.

The object of the invention is to overcome the aforementioned drawbacks of known current bit cell structures.

Its subject is therefore a current bit cell used in the construction of a switched network comprising a current source, FET means for detecting the presence of a digital signal bit and FET means for detecting at least one command signal so as to provide first FET means for controlling on a first output of the cell, the appearance of a current delivered by the current source as a function of the digital signal applied to the said cell and of the said at least one command signal, characterized in that it furthermore includes FET means for detecting the presence of a bit complementary to the bit of the digital signal and FET means for detecting the complement of the said at least one command signal, so as to provide second FET means for controlling on a second output of the cell as a function of the complementary digital signal and of said complement of said at least one command signal the appearance of a current delivered by the current source which is the complement of the current delivered on the first output, the said FET means for detecting the presence of bits and of the said at least one command signal, the said FET means for detecting the presence of complementary bits and of complementary signals, the said FET means for controlling the appearance of currents and the said current source being embodied with the aid of field-effect transistors of the same type.

According to other characteristics of the invention:
- the current bit cell, used in the construction of a switched current network formed of rows and columns of the said cells, characterized in that the said FET means for detecting at least one command signal comprise FET means for detecting the status of the cell and FET means for detecting the status of a row of cells to which the said cell belongs, whilst the FET means for detecting the complement of the said at least one command signal comprise FET means for detecting the complement of the status of the said cell and FET means for detecting the complement of the status of the row of cells to which the said cell belongs.
- the said FET means for detecting the presence of a digital signal bit, the FET means for detecting the said at least one command signal and the FET means for controlling the appearance of a current on the first output form, with the FET means for detecting the presence of the said complementary bit, the FET means for detecting the said complement of the said at least one command signal and the FET means for controlling the appearance of a current on the second output, a FET means set-up which is symmetric with respect to the current source.
- the current source is formed of a transistor whose drain is connected to the sources of a first and of a second transistor forming the FET means for detecting the status of the cell and to the sources of a first and second transistor forming the FET means for detecting the complement of the status of the said cell.
- the source of the first transistor for detecting the status of the cell is connected to the current source and its drain to the source of a transistor forming the FET means for detecting the presence of a digital signal bit, whilst the source of the first transistor, for detecting the complement of the status of the cell is connected to the current source and its drain to the source of a transistor forming the FET means for detecting the status of the row of cells to which the said cell belongs, the drains of the said transistors for detecting the presence of a digital signal bit and for detecting the status of the row to which the cell belongs being connected to the first output, the said first transistor for detecting the status of the cell, the first transistor for detecting the complement of the status of the cell, the said transistor for detecting the presence of a digital signal bit and the said transistor for detecting the status of the row of cells to which the said cell belongs forming the said first FET means for controlling the appearance of a current on the first output.
- the source of the second transistor for detecting the status of the cell is connected to the current source and its drain to the source of a transistor forming the FET means for detecting the presence of the complement of the digital signal bit, whilst the source of the second transistor for detecting the complement of the status of the cell is connected to the current source and its drain to the source of a transistor forming the FET means for detecting the complement of the status of the row of cells to which the said cell belongs, the drains of the said transistors for detecting the presence of the complement of the digital signal bit and for detecting the complement of the status of the row to which the cell belongs to, being connected to the second output, the said second transistor for detecting the complement of the status of the cell, the said second transistor for detecting the status of the cell, the said transistor for detecting the presence of the complementary bit and the said transistor for detecting the complement of the status of the row of cells to which the said cell belongs forming the said second FET means for controlling the appearance of a current on the second output.
- the current source is formed of a transistor whose drain is connected to the sources of a transistor forming the FET means for detecting the presence of a digital signal bit, of a first transistor for detecting the complementary signal of the status of the cell and of a transistor forming the FET means for detecting the presence of the complementary signal of the digital signal bit, a second transistor, forming with the first transistor for detecting the complementary signal of the status of the cell the FET means for detecting the presence of the complementary signal of the status of the cell, having its drain connected to the drain of the transistor for detecting the presence of a digital signal bit and its source connected to the drain of the transistor for detecting the presence of the complementary signal, the source of the transistor for detecting the presence of a digital signal bit being connected to the current source and its drain to the source of a first transistor for detecting the status of the cell, the source of the first transistor for detecting the complementary signal of the status of the cell being connected to the current source and its drain to the source of a transistor for detecting the status of the row of cells to which the said cell belongs and, with the source of a transistor forming the FET means for detecting the complementary signal of the status of the said row of cells, the source of the transistor for detecting the complementary signal of the digital signal bit being connected to the current source and its drain to the source of a second transistor forming, with the first transistor for detecting the status of the cell, the FET means for detecting the status of the cell, the drains of the first and second transistors for detecting the status of the cell being respectively connected with the drain of the transistor for detecting the status of the row of cells and with the drain of the transistor for detecting the complementary signal of the status of the row of cells to the first and second outputs of the cell, the said transistor for detecting the presence of a digital signal bit, the said first transistor for detecting the complementary signal of the status of the cell, the said first transistor for detecting the status of the cell and the said transistor for detecting the status of the row of cells to which the said cell belongs forming said first means for controlling the appearance of a current on the first output, the said transistor for detecting the presence of the complementary signal of the digital signal bit, the said first transistor for detecting the complementary signal of the status of the cell, the said second transistor for detecting the status of the cell and the said transistor for detecting the complementary signal of the status of the row of cells to which the said cell belongs forming the said second FET means for controlling the appearance of a current on the second output.

A further subject of the invention is a switched current network, characterized in that it is formed of current bit cells of the type defined above, laid out in rows and columns, the first and second outputs of the said cells being respectively connected together and in that the said cells of the network are laid out around the center of the network divided into four quadrants in such a way as to be commanded in accordance with a sequence in which command of a cell situated in a quadrant is followed by command of a cell situated in a quadrant symmetric with the previous quadrant with respect to the center of the network.

The invention will be understood more clearly on reading the following description, given solely by way of example and made with reference to the appended drawings, in which,
- Fig. 1 represents the circuit diagram of a known current bit cell;
- Fig. 2 is a decoding scheme for a network of current bit cells of the type represented in Figure 1;
- Fig. 3 is a decoding scheme for a network with pseudo-centroid topology;
- Fig. 4 is a circuit diagram of a current bit cell according to the invention;
- Fig. 5 is a circuit diagram, similar to the one in Figure 4, showing the stray capacitances at certain points of the circuit; and
- Fig.6 is a circuit diagram of a current bit cell according to the invention, improved in order to avoid the stray capacitances.

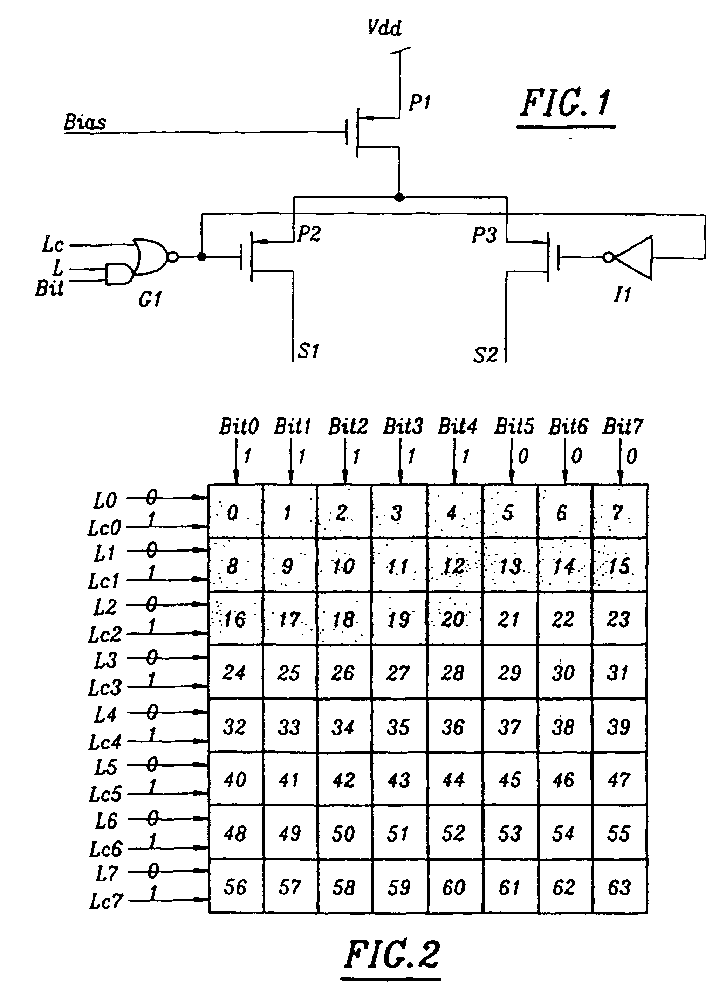

One known way of carrying out the decoding is that of using the current bit cell represented in Figure 1.

This current bit cell includes a decoding part with a complex gate G1 and an invertor I1 in CMOS technology, employing four N-channel transistors and four P-channel transistors, and the current bit cell proper comprising a current source P1 and two switches P2 and P3, formed by three P-channel transistors, which makes eleven transistors in total.

By using this type of cell, a network can be produced as an array of Y rows and X columns, and the decoding scheme represented in Figure 2 is then as follows.

All the current bit cells of a single row are connected to the same row-decoding signal L and to a full row-decoding signal Lc, while all the rows of current bits in a single column are connected to a column decoding signal Bit.

A current bit cell such as the one in Figure 1 is defined as active when the current flows through the output S1.

By using this decoding scheme, each individual current bit cell can be activated when its row (signal L) and its column (signal Bit) are active, whereas all the current bit cells of a row are activated when the entire row (signal Lc) is active.

This makes it possible to employ a technique of adding an element to each step of a digital code, by starting with activation of the first current bit cell of the first row with the first code, by adding a bit of the same column for the following code, and so on.

When the row being filled is complete, its signal Lc becomes active and the filling of the following row starts with its first current bit cell.

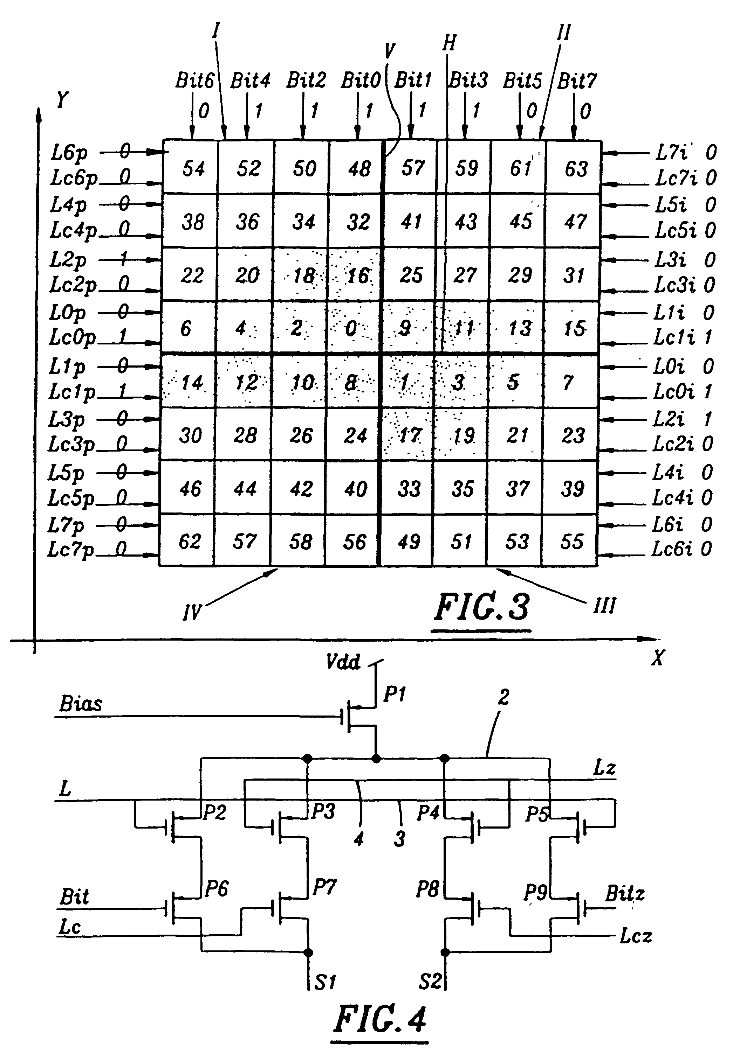

By rearranging the topology of the network in the manner represented in Figure 3, a pseudo-centroid topology can be obtained, in which the successive activated current bit cells are laid out quasi-symmetrically with respect of the centre of the network.

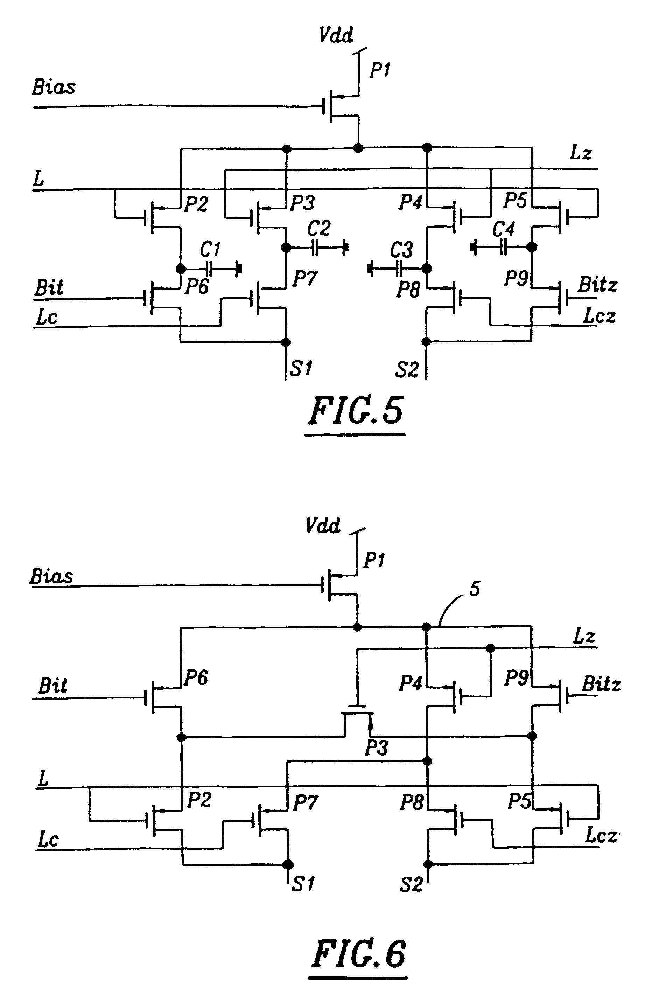

This network, implementation of which is particularly suited to the use of cells according to the invention, such as the cells described with reference to Figures 4 to 6, is organised in the form of a network of Y rows and X columns.

According to the invention, it is divided into four quadrants I, II, III, IV, and the numbering of its cells from 0 to 63 expresses their order of command according to a sequence in which the commanding of a cell, such that the cell No. 0 located in a quadrant I of the network is followed by the commanding of a cell such as the cell No. 1 located in a quadrant III which is symmetrical to the previous quadrant with respect to the centre of the network manifested by the intersection of the lines V and H separating the network into four quadrants.

In Figure 3, the activated cells corresponding to an input code detected by the network are represented in grey.

The digital signals Bit 0 to Bit 7 are applied in turn to cells located on either side of the vertical line V separating the network into two superposed equal parts.

The cell status signals L and the row status signals Lc are applied in turn to cells located on either side of the horizontal line H separating the network into two juxtaposed equal parts.

The signals L, Lc applied to the even and odd cells are respectively suffixed p and i.

In the network, the signals S1 of all the current bit cells are connected together, and the signals S2 of all the current bit cells are connected together. This leads to provision at the output S2 of the complement of the current at the output S1 with respect to the total current flowing in the network.

If only the current available at one of the outputs S1 or S2 is used, for the subsequent operation, the network will be referred to as unipolar.

If the difference in current available on S1 and S2 is used for the subsequent operation, the network will be referred to as differential.

However, implementation of a current bit cell as represented in Figure 1 raises a number of drawbacks.

It requires the use of N-type and P-type transistors, which, as indicated above, means that the packing density of the cell cannot be optimised because of the need for two different types of substrates.

A second drawback is the asymmetric structure, one switch being controlled by the complex gate G1 and the second switch being controlled by the invertor I1; which makes the cell unsuitable tor differential networks.

In particular, the delay between the commanding of the two switches due to the invertor I1 introduces an electrical asymmetry between the two outputs, which negates some of the advantages of the differential circuit.

The proposed solution is represented in Figure 4. The proposed current bit cell comprises a current source P1 and a set of eight switches P2 to P9 controlled by logic bit signals Bit, Bitz, L, Lz, Lc and Lcz.

The suffix z indicates the complement. For example, the signal Bitz is the complement of the signal Bit.

There are therefore in total nine field-effect transistors.

It will be noted that the current source may use more than one transistor in the case of a current source produced in cascode in order to improve the precision of the current.

The current bit cell represented in Figure 4 includes a current source P1 formed by a P-channel transistor whose source is connected to a voltage Vdd, whose gate receives a Bias signal and whose drain is connected to a line connecting the sources of four P-channel transistors P2, P3, P4 and P5.

The gates of the transistors P2 and P5 are connected to an L signal line 3.

The gates of the transistors P3 and P4 are connected to an Lz signal line 4.

The drains of the transistors P2, P3, P4 and P5 are connected respectively to the sources of the corresponding P-channel transistors P6, P7, P8 and P9.

The gate of the transistor P6 receives the signal Bit, the gate of the transistor P7 receives the signal Lc, the gate of the transistor P8 receives the signal Lcz and the gate of the transistor P9 receives the signal Bitz.

The drains of the transistors P6 and P7 are connected to a common output terminal S1, whereas the drains of the transistors P8 and P9 are connected to a common output terminal S2.

As in the description above, the current bit cells in which the current is switched to the output S1 will be defined as being active.

This current bit cell allows the same decoding scheme as the cell in Figure 1, that is to say that each individual cell can be activated, when the signals Bit are active, by means of the transistors P2 and P6, while the current bit cells of each entire row can be activated, when the signal Lc is active, by means of the transistors P3 and P7.

For the inactive current bit cells, the current is diverted to the output S2 when the signals Bit and L are inactive or when the entire row is inactive (Lc inactive).

One advantage of this current bit cell over the one represented in Figure 1 resides in the fact that it uses only nine transistors instead of eleven, that all the transistors are of the same type (in the proposed solution, these are P-channel transistors, but the current bit cell may also be produced with ease using N-channel transistors). This makes it possible to obtain a higher packing density, and consequently to use smaller silicon surfaces.

The second advantage of the arrangement of the invention resides in the fact that this structure is symmetrical from a topological point of view and symmetrical from an electrical point of view with respect to the source, on condition that the command signals Bit, L and Lc are symmetrical (no delay and the same transition time) with regard to their respective complements Bitz, Lz and Lcz. This symmetry of the command signals can be obtained with ease by using suitable circuits.

Next, this topological and electrical symmetry of the current bit cell allows full benefit to be made of the advantages cf the differential circuits.

However, an additional analysis of the current bit cell in Figure 4 still shows minor imperfections which may lead to errors in the circuit current which are unacceptable in high-precision systems. These imperfections are due to the unavoidable presence of stray capacitances on the nodes between the switches connected in series.

Figure 5 shows these capacitances C1, C2, C3 and C4 in a structure of the same type as the one represented in Figure 4.

A first source of error results from the following phenomenon.

In the current bit cells activated by the command signal Lc (full row-decoding signal), the current originating from the source is switched to the output S1, the command signal L is inactive, turning the transistor P2 off and the signal Bit is toggled as a function of the decoding of the current bit cells of the row which is active or being filled. The coupling between the common node of the transistors P2 and P6 and the signal Bit leads to a stray charge on the capacitor C1 when the transistor P6 is switched off.

When the transistor P6 is turned on again, the stray charges on the capacitor C1 are removed through the output S1, leading to a transient error in the current at S1.

A second source of errors results from the following phenomenon.

In a current bit cell which is active or being filled, the command signal L is active (Lz is inactive) and the command signal Lc is inactive. This leads to the transistors P3 and P7 being switched off and makes the node common to P3 and P7 floating.

Because of the coupling, the capacitance C2 is charged with the stray charges which will be removed through the output S1 when the command signal Lc becomes active, also causing a transient error in the current at S1.

In order to overcome these drawbacks, an improved structure of current bit cells is represented in Figure 6.

In this figure, the components entering into the construction of the circuit which have the same functions as those of the components of the circuit in Figure 4, bear the same references.

Firstly, the circuit includes a current source consisting of the P-channel transistor P1, the source of which is connected to a voltage Vdd, the gate of which receives the signal Bias and the drain of which is connected to a line 5 connecting the sources of transistor P6, the gate of which is connected to the signal Bit, of the transistor P4, the gate of which is connected to the signal Lz, and of the transistor P9, the gate of which receives the signal Bitz.

The drain-source path of the P-channel transistor P3, the gate of which also receives the signal Lz, is connected between the drains of the transistors P6 and P9.

The drain of the transistor P6 is connected to the source of the transistor P2, the drain of the transistor P4 is connected to the source of the transistor P7 and to the source of the transistor P8, and the drain of the transistor P9 is connected to the source of the transistor P5.

The gates of the transistors P2 and P5 receive the signal L, while the gate of the transistor P7 receives the signal Lc and the gate of the transistor P8 receives the signal Lcz.

The drains of the transistors P2 and P7 are connected to the output S1, while the drains of the transistors P5 and P8 are connected to the output S2.

This structure avoids a node being left floating for any decoding status of the current bit cell. To this end, the position of the switches controlled by the signals Bit in the case of the transistor P6, and L in the case of the transistor P2, have been exchanged and the switch P3 has been placed between the common node of the transistors P2, P6 and P5, P9. With this structure, when the signal L is inactive, there is a path from the common node of P2, P6 and P5, P9 to S1 or S2, avoiding a floating status on the node P2, P6 or P5, P9.

The switches P7 and P8 respectively controlled by the signals Lc and Lcz are connected to a single switch P4, controlled by the signal Lz.

This configuration makes the floating status impossible at the node common to the transistors P4, P7 and P8, since a path from this node to the terminals S1 or S2 exists for any existing combinations of the signals Bit, L and Lc, as well as for the signals Bitz, Lz and Lcz.

Because, in most applications, the voltages at the nodes S1 and S2 are kept equal and constant, all the nodes of the current bit cell are always at the same voltage, and no stray capacitive charge produces error in the current at the outputs S1 or S2.

This novel structure also uses only nine transistors, all of the same type, and conserves a topological and electrical symmetry.

## Claims

1. Current bit cell used in the construction of a switched network comprising a current source (P1), FET means for detecting the presence of a digital signal bit (Bit) and FET means (P2, P5, P7) for detecting at least one command signal (L, Lc) so as to provide first FET means (P2,P3,P6,P7; P2,P4,P6,P7) for controlling on a first output (S1) of the cell, the appearance of a current delivered by the current source (P1) as a function of the digital signal (Bit) applied to the said cell and of the said at least one command signal (L, Lc), **characterized in that** it furthermore includes FET means (P9) for detecting the presence of a bit (Bitz) complementary to the bit of the digital signal (Bit) and FET means (P3,P4,P8) for detecting the complement (Lz, Lcz) of the said at least one command signal (L, Lc), so as to provide second FET means (P4,P5,P8,P9) for controlling on a second output (S2) of the cell as a function of the complementary digital signal (Bitz) and of said complement (Lz, Lcz) of said at least one command signal the appearance of a current delivered by the current source (P1) which is the complement of the current delivered on the first output (S1), the said FET means for detecting the presence of bits and of the said at least one command signal, the said FET means for detecting the presence of complementary bits and of complementary signals, the said FET means for controlling the appearance of currents and the said current source being embodied with the aid of field-effect transistors of the same type.

2. Current bit cell according to Claim 1, used in the construction of a switched current network formed of rows and columns of the said cells, **characterized in that** the said FET means for detecting at least one command signal comprise FET means (P2, P5) for detecting the status (L) of the cell and FET means (P7) for detecting the status (Lc) of a row of cells to which the said cell belongs, whilst the FET means for detecting the complement of the said at least one command signal comprise FET means (P3, P4) for detecting the complement (Lz) of the status of the said cell and FET means (P8) for detecting the complement(Lcz) of the status of the row of cells to which the said cell belongs.

3. Current bit cell according to one of Claims 1 and 2, **characterized in that** the said FET means (P6) for detecting the presence of a digital signal bit, the FET means (P2, P5, P7) for detecting the said at least one command signal (L, Lc) and the FET means for controlling the appearance of a current on the first output (S1) form, with the FET means (P9) for detecting the presence of the said complementary bit, the FET means (P3, P4, P8) for detecting the said complement (Lz, Lcz) of the said at least one command signal and the FET means for controlling the appearance of a current on the second output (S2), a FET means set-up which is symmetric with respect to the current source (P1).

4. Current bit cell according to one of Claims 2 and 3, **characterized in that** the current source is formed of a transistor (P1) whose drain is connected to the sources of a first and of a second transistor (P2, P5) forming the FET means for detecting the status (L) of the cell and to the sources of a first and second transistor (P3, P4) forming the FET means for detecting the complement (Lz) of the status of the said cell.

5. Current bit cell according to Claim 4, **characterized in that** the source of the first transistor (P2) for detecting the status (L) of the cell is connected to the current source (P1) and its drain to the source of a transistor (P6) forming the FET means for detecting the presence of a digital signal bit (Bit), whilst the source of the first transistor (P3) for detecting the complement (Lz) of the status of the cell is connected to the current source (P1) and its drain to the source of a transistor (P7) forming the FET means for detecting the status (Lc) of the row of cells to which the said cell belongs, the drains of the said transistors (P6, P7) for detecting the presence of a digital signal bit and for detecting the status (Lc) of the row to which the cell belongs being connected to the first output (S1), the said first transistor (P2) for detecting the status (L) of the cell, the first transistor (P3) for detecting the complement (Lz) of the status of the cell, the said transistor (P6) for detecting the presence of a digital signal bit(Bit) and the said transistor (P7) for detecting the status (Lc) of the row of cells to which the said cell belongs forming the said first FET means for controlling the appearance of a current on the first output (S1).

6. Current bit cell according to Claims 4 and 5, **characterized in that** the source of the second transistor (P5) for detecting the status (L) of the cell is connected to the current source (P1) and its drain to the source of a transistor (P9) forming the FET means for detecting the presence of the complement (Bitz) of the digital signal bit, whilst the source of the second transistor (P4) for detecting the complement (Lz) of the status of the cell is connected to the current source (P1) and its drain to the source of a transistor (P8) forming the FET means for detecting the complement (Lcz) of the status of the row of cells to which the said cell belongs, the drains of the said transistors (P8, P9) for detecting the presence of the complement (Bitz) of the digital signal bit and for detecting the complement (Lcz) of the status of the row to which the cell belongs to, being connected to the second output (S2), the said second transistor (P4) for detecting the complement (Lz) of the status of the cell, the said second transistor (P5) for detecting the status (L) of the cell, the said transistor (P9) for detecting the presence of the complementary bit (Bitz) and the said transistor (P8) for detecting the complement (Lcz) of the status of the row of cells to which the said cell belongs forming the said second FET means for controlling the appearance of a current on the second output (S2).

7. Current bit cell according to one of Claims 2 and 3, **characterized in that** the current source is formed of a transistor (P1) whose drain is connected to the sources of a transistor (P6) forming the FET means for detecting the presence of a digital signal bit (Bit), of a first transistor (P4) for detecting the complementary signal (Lz) of the status of the cell and of a transistor (P9) forming the FET means for detecting the presence of the complementary signal (Bitz) of the digital signal bit, a second transistor (P3), forming with the first transistor (P4) for detecting the complementary signal (Lz) of the status of the cell the FET means for detecting the presence of the complementary signal (Lz) of the status of the cell, having its drain connected to the drain of the transistor (P6) for detecting the presence of a digital signal bit (Bit) and its source connected to the drain of the transistor (P9) for detecting the presence of the complementary signal (Bitz), the source of the transistor (P6) for detecting the presence of a digital signal bit being connected to the current source (P1) and its drain to the source of a first transistor (P2) for detecting the status (L) of the cell, the source of the first transistor (P4) for detecting the complementary signal (Lz) of the status of the cell being connected to the current source (P1) and its drain to the source of a transistor (P7) for detecting the status (Lc) of the row of cells to which the said cell belongs and, with the source of a transistor(P8)forming the FET means for detecting the complementary signal (Lcz) of the status of the said row of cells, the source of the transistor (P9) for detecting the complementary signal (Bitz) of the digital signal bit being connected to the current source (P1) and its drain to the source of a second transistor (P5) forming, with the first transistor (P2) for detecting the status (L) of the cell, the FET means for detecting the status (L) of the cell, the drains of the first and second transistors (P2, P5) for detecting the status (L) of the cell being respectively connected with the drain of the transistor (P7) for detecting the status (Lc) of the row of cells and with the drain of the transistor (P8) for detecting the complementary signal (Lcz) of the status of the row of cells to the first and second outputs (S1, S2) of the cell, the said transistor (P6) for detecting the presence of a digital signal bit (Bit), the said first transistor (P4) for detecting the complementary signal (Lz) of the status of the cell, the said first transistor (P2) for detecting the status (L) of the cell and the said transistor (P7) for detecting the status (Lc) of the row of cells to which the said cell belongs forming said first means for controlling the appearance of a current on the first output (S1), the said transistor (P9) for detecting the presence of the complementary signal (Bitz) of the digital signal bit, the said first transistor (P4) for detecting the complementary signal (Lz) of the status of the cell, the said second transistor (P5) for detecting the status (L) of the cell and the said transistor (P8) for detecting the complementary signal (Lcz) of the status of the row of cells to which the said cell belongs forming the said second FET means for controlling the appearance of a current on the second output (S2).

8. Switched current network, **characterized in that** it is formed of current bit cells according to any one of Claims 1 to 7, laid out in rows and columns, the first and second outputs of the said cells being respectively connected together and **in that** the said cells of the network are laid out around the center of the network divided into four quadrants in such a way as to be commanded in accordance with a sequence in which command of a cell situated in a quadrant is followed by command of a cell situated in a quadrant symmetric with the previous quadrant with respect to the center of the network.

## Patentansprüche

1. Strombitzelle, die in der Konstruktion eines Schaltnetzwerks verwendet wird, mit einer Stromquelle (P1), FET-Mitteln zum Erfassen des Vorhandenseins eines digitalen Signalbits (Bit) und FET-Mitteln (P2, P5, P7) zum Erfassen wenigstens eines Befehlsignals (L, Lc), womit erste FET-Mittel (P2, P3, P6, P7; P2, P4, P6, P7) geschaffen werden, um an einem ersten Ausgang (S1) der Zelle das Auftreten eines Stroms, der von der Stromquelle (P1) geliefert wird, als Funktion des digitalen Signals (Bit), das in die Zelle eingegeben wird, und des wenigstens einen Befehlssignals (L, Lc) zu steuern, **dadurch gekennzeichnet, dass** sie ferner FET-Mittel (P9) zum Erfassen des Vorhandenseins eines zu dem Bit (Bit) des digitalen Signals komplementären Bits (Bitz) und FET-Mittel (P3, P4, P8) zum Erfassen des Komplements (Lz, Lcz) des wenigstens einen Befehlsignals (L, Lc) umfasst, womit zweite FET-Mittel (P4, P5, P8, P9) geschaffen werden, um an einem zweiten Ausgang (S2) der Zelle das Vorhandensein eines von der Stromquelle (P1) gelieferten Stroms, der das Komplement des von dem ersten Ausgang (S1) gelieferten Stroms ist, als Funktion des komplementären digitalen Signals (Bitz) und des Komplements (Lz, Lcz) des wenigstens einen Befehlsignals zu steuern, wobei die FET-Mittel zum Erfassen des Vorhandenseins von Bits und des wenigstens einen Befehlsignals, die FET-Mittel zum Erfassen des Vorhandenseins komplementärer Bits und komplementärer Signale und die FET-Mittel zum Steuern des Vorhandenseins von Strömen sowie die Stromquelle mit Hilfe von Feldeffekttransistoren desselben Typs verwirklicht sind.

2. Strombitzelle nach Anspruch 1, die in der Konstruktion eines Schaltstromnetzwerks verwendet wird, das aus Zeilen und Spalten solcher Zellen gebildet ist, **dadurch gekennzeichnet, dass** die FET-Mittel zum Erfassen wenigstens eines Befehlsignals FET-Mittel (P2, P5) zum Erfassen des Status (L) der Zelle und FET-Mittel (P7) zum Erfassen des Status (Lc) einer Zeile von Zellen, zu der die Zelle gehört, umfassen, während die FET-Mittel zum Erfassen des Komplements des wenigstens einen Befehlssignal FET-Mittel (P3, P4) zum Erfassen des Komplements (Lz) des Status der Zelle und FET-Mittel (P8) zum Erfassen des Komplements (Lcz) des Status der Zeile von Zellen, zu der die Zelle gehört, umfassen.

3. Strombitzelle nach einem der Ansprüche 1 und 2, **dadurch gekennzeichnet, dass** die FET-Mittel (P6) zum Erfassen des Vorhandenseins eines digitalen Signalbits, die FET-Mittel (P2, P5, P7) zum Erfassen des wenigstens einen Befehlsignals (L, Lc) und die FET-Mittel zum Steuern des Vorhandenseins eines Stroms am ersten Ausgang (S1) zusammen mit den FET-Mitteln (P9) zum Erfassen des Vorhandenseins des komplementären Bits, den FET-Mitteln (P3, P4, P8) zum Erfassen des Komplements (Lz, Lcz) des wenigstens einen Befehlssignals und den FET-Mitteln zum Steuern des Vorhandenseins eines Stroms am zweiten Ausgang (S2) einen FET-Mittel-Aufbau bilden, der in Bezug auf die Stromquelle (P1) symmetrisch ist.

4. Strombitzelle nach einem der Ansprüche 2 und 3, **dadurch gekennzeichnet, dass** die Stromquelle aus einem Transistor (P1), dessen Drain mit den Sources eines ersten und eines zweiten Transistors (P2, P5), die die FET-Mittel zum Erfassen des Status (L) der Zelle bilden, und mit den Sources eines ersten und eines zweiten Transistors (P3, P4), die die FET-Mittel zum Erfassen des Komplements (Lz) des Status der Zelle bilden, verbunden ist.

5. Strombitzelle nach Anspruch 4, **dadurch gekennzeichnet, dass** die Source des ersten Transistors (P2) zum Erfassen des Status (L) der Zelle mit der Stromquelle (P1) verbunden ist, wobei dessen Drain mit der Source eines Transistors (P6) verbunden ist, der die FET-Mittel zum Erfassen des Vorhandenseins eines digitalen Signalbits (Bit) bildet, während die Source des ersten Transistors (P3) zum Erfassen des Komplements (Lz) des Status der Zelle mit der Stromquelle (P1) verbunden ist, wobei dessen Drain mit der Source eines Transistors (P7) verbunden ist, der die FET-Mittel zum Erfassen des Status (Lc) der Zeile von Zellen, zu der die Zelle gehört, bildet, wobei die Drains der Transistoren (P6, P7) zum Erfassen des Vorhandenseins eines digitalen Signalbits und zum Erfassen des Status (Lc) der Zeile, zu der die Zelle gehört, mit dem ersten Ausgang (S1) verbunden sind, wobei der erste Transistor (P2) zum Erfassen des Status (L) der Zelle, der erste Transistor (P3) zum Erfassen des Komplements (Lz) des Status der Zelle, der Transistor (P6) zum Erfassen des Vorhandenseins eines digitalen Signalbits (Bit) und der Transistor (P7) zum Erfassen des Status (Lc) der Zeile von Zellen, zu der die Zelle gehört, die ersten FET-Mittel zum Steuern des Vorhandenseins eines Stroms am ersten Ausgang (S1) bilden.

6. Strombitzelle nach den Ansprüchen 4 und 5, **dadurch gekennzeichnet, dass** die Source des zweiten Transistors (P5) zum Erfassen des Status (L) der Zelle mit der Stromquelle (P1) verbunden ist, wobei dessen Drain mit der Source eines Transistors (P9) verbunden ist, der die FET-Mittel zum Erfassen des Vorhandenseins des Komplements (Bitz) des digitalen Signalbits bildet, während die Source des zweiten Transistors (P4) zum Erfassen des Komplements (Lz) des Status der Zelle mit der Stromquelle (P1) verbunden ist, wobei dessen Drain mit der Source eines Transistors (P8) verbunden ist, der die FET-Mittel zum Erfassen des Komplements (Lcz) des Status der Zeile von Zellen, zu der die Zelle gehört, bildet, wobei die Drains der Transistoren (P8, P9) zum Erfassen des Vorhandenseins des Komplements (Bitz) des digitalen Signalbits und zum Erfassen des Komplements (Lcz) des Status der Zeile, zu der die Zelle gehört, mit dem zweiten Ausgang (S2) verbunden sind und der zweite Transistor (P4) zum Erfassen des Komplements (Lz) des Status der Zelle, der zweite Transistor (P5) zum Erfassen des Status (L) der Zelle, der Transistor (P9) zum Erfassen des Vorhandenseins des komplementären Bits (Bitz) und der Transistor (P8) zum Erfassen des Komplements (Lcz) des Status der Zeile von Zellen, zu der die Zelle gehört, die zweiten FET-Mittel zum Steuern des Vorhandenseins eines Stroms am zweiten Ausgang (S2) bilden.

7. Strombitzelle nach einem der Ansprüche 2 und 3, **dadurch gekennzeichnet, dass** die Stromquelle gebildet ist aus einem Transistor (P1), dessen Drain mit den Sources eines Transistors (P6) verbunden ist, der die FET-Mittel zum Erfassen des Vorhandenseins eines digitalen Signalbits (Bit) bildet, aus einem ersten Transistor (P4) zum Erfassen des komplementären Signals (Lz) des Status der Zelle und aus einem Transistor (P9), der die FET-Mittel zum Erfassen des Vorhandenseins des komplementären Signals (Bitz) des digitalen Signalbits bildet, wobei ein zweiter Transistor (P3), der zusammen mit dem ersten Transistor (P4) zum Erfassen des komplementären Signals (Lz) des Status der Zelle die FET-Mittel zum Erfassen des Vorhandenseins des komplementären Signals (Lz) des Status der Zelle bildet, mit seinem Drain mit dem Drain des Transistors (P6) zum Erfassen des Vorhandenseins eines digitalen Signalbits (Bit) verbunden ist und mit seiner Source mit dem Drain des Transistors (P9) zum Erfassen des Vorhandenseins des komplementären Signals (Bitz) verbunden ist, wobei die Source des Transistors (P6) zum Erfassen des Vorhandenseins eines digitalen Signalbits mit der Stromquelle (P1) verbunden ist und dessen Drain mit der Source eines ersten Transistors (P2) zum Erfassen des Status (L) der Zelle verbunden ist, wobei die Source des ersten Transistors (P4) zum Erfassen des komplementären Signals (Lz) des Status der Zelle mit der Stromquelle (P1) verbunden ist und dessen Drain mit der Source eines Transistors (P7) zum Erfassen des Status (Lc) der Zeile von Zellen, zu der die Zelle gehört, und mit der Source eines Transistors (P8), der FET-Mittel zum Erfassen des komplementären Signals (Lcz) des Status der Zeile von Zellen bildet, verbunden ist, wobei die Source des Transistors (P9) zum Erfassen des komplementären Signals (Bitz) des digitalen Signalbits mit der Stromquelle (P1) verbunden ist und dessen Drain mit der Source eines zweiten Transistors (P5) verbunden ist, der zusammen mit dem ersten Transistor (P2) zum Erfassen des Status (L) der Zelle die FET-Mittel zum Erfassen des Status (L) der Zelle bildet, wobei die Drains des ersten und des zweiten Transistors (P2, P5) zum Erfassen des Status (L) der Zelle zusammen mit dem Drain des Transistors (P7) zum Erfassen des Status (Lc) der Zeile von Zellen bzw. zusammen mit dem Drain des Transistors (P8) zum Erfassen des komplementären Signals (Lcz) des Status der Zeile von Zellen mit dem ersten bzw. mit dem zweiten Ausgang (S1, S2) der Zelle verbunden sind, wobei der Transistor (P6) zum Erfassen des Vorhandenseins eines digitalen Signalbits (Bit), der erste Transistor (P4) zum Erfassen des komplementären Signals (Lz) des Status der Zelle, der erste Transistor (P2) zum Erfassen des Status (L) der Zelle und der Transistor (P7) zum Erfassen des Status (Lc) der Zeile von Zellen, zu der die Zelle gehört, die ersten Mittel zum Steuern des Vorhandenseins eines Stroms am ersten Ausgang (S1) bilden, wobei der Transistor (P9) zum Erfassen des Vorhandenseins des komplementären Signals (Bitz) des digitalen Signalbits, der erste Transistor (P4) zum Erfassen des komplementären Signals (Lz) des Status der Zelle, der zweite Transistor (P5) zum Erfassen des Status (L) der Zelle und der Transistor (P8) zum Erfassen des komplementären Signals (Lcz) des Status der Zeile von Zellen, zu der die Zelle gehört, die zweiten FET-Mittel zum Steuern des Vorhandenseins eines Stroms am zweiten Ausgang (S2) bilden.

8. Schaltstromnetzwerk, **dadurch gekennzeichnet, dass** es aus Strombitzellen nach einem der Ansprüche 1 bis 7 gebildet ist und in Zeilen und Spalten entworfen ist, wobei der erste und der zweite Ausgang der Zellen jeweils miteinander verbunden sind, und dass die Zellen des Netzwerks um das Zentrum des Netzwerks entworfen sind, das seinerseits in vier Quadranten unterteilt ist, derart dass sie in Übereinstimmung mit einer Sequenz gesteuert werden, in der einem Befehl einer Zelle, die sich in einem Quadranten befindet, ein Befehl einer Zelle folgt, die sich in einem Quadranten befindet, der zu dem vorhergehenden Quadranten in Bezug auf das Zentrum des Netzwerks symmetrisch ist.

## Revendications

1. Cellule de bit de courant utilisée dans la construction d'un réseau commuté comprenant une source de courant (P1), des moyens à transistor à effet de champ pour détecter la présence d'un bit de signal numérique (Bit) et des moyens à transistor à effet de champ (P2, P5, P7) pour détecter au moins un signal de commande (L, Lc) afin de fournir des premiers moyens à transistor à effet de champ (P2, P3, P6, P7 ; P2, P4, P6, P7) pour commander, sur une première sortie (S1) de la cellule, l'apparition d'un courant délivré par la source de courant (P1) en fonction du signal numérique (Bit) appliqué à ladite cellule et dudit au moins un signal de commande (L, Lc), **caractérisée en ce qu'**elle comprend en outre des moyens à transistor à effet de champ (P9) pour détecter la présence d'un bit (Bitz) complémentaire du bit de signal numérique (Bit) et des moyens à transistor à effet de champ (P3, P4, P8) pour détecter le complément (Lz, Lcz) dudit au moins un signal de commande (L, Lc) afm de fournir des seconds moyens à transistor à effet de champ (P4, P5, P8, P9) pour commander sur une seconde sortie (S2) de la cellule en fonction du signal numérique complémentaire (Bitz) et dudit complément (Lz, Lcz) dudit au moins un signal de commande, l'appantion d'un courant délivré par la source de courant (P1) qui est le complément du courant délivré sur la première sortie (S1), lesdits moyens à transistor à effet de champ pour détecter la présence de bits et dudit au moins un signal de commande, lesdits moyens à transistor à effet de champ pour détecter la présence de bits complémentaires et de signaux complémentaires, lesdits moyens à transistor à effet de champ pour commander l'apparition de courants et ladite source de courant étant mis en oeuvre à l'aide de transistors à effet de champ du même type.

2. Cellule de bit de courant selon la revendication 1, utilisée dans la construction d'un réseau à courant commuté formé de rangées et de colonnes desdites cellules, **caractérisée en ce que** lesdits moyens à transistor à effet de champ pour détecter au moins un signal de commande comprennent des moyens à transistor à effet de champ (P2, P5) pour détecter l'état (L) de la cellule et des moyens à transistor à effet de champ (P7) pour détecter l'état (Lc) d'une rangée de cellules à laquelle ladite cellule appartient, alors que les moyens à transistor à effet de champ pour détecter le complément dudit au moins un signal de commande comprennent des moyens à transistor à effet de champ (P3, P4) pour détecter le complément (Lz) de l'état de ladite cellule et des moyens à transistor à effet de champ (P8) pour détecter le complément (Lcz) de l'état de la rangée de cellules à laquelle ladite cellule appartient.

3. Cellule de bit de courant selon l'une quelconque des revendications 1 et 2, **caractérisée en ce que** lesdits moyens à transistor à effet de champ (P6) pour détecter la présence d'un bit de signal numérique, les moyens à transistor à effet de champ (P2, P5, P7) pour détecter ledit au moins un signal de commande (L, Lc) et les moyens à transistor à effet de champ pour commander l'apparition d'un courant sur la première sortie (S1) forment avec les moyens à transistor à effet de champ (P9) pour détecter la présence dudit bit complémentaire, les moyens à transistor à effet de champ (P3, P4, P8) pour détecter ledit complément (Lz, Lcz) dudit au moins un signal de commande et les moyens à transistor à effet de champ pour commander l'apparition d'un courant sur la seconde sortie (S2), une configuration de moyens à transistor à effet de champ qui est symétrique par rapport à la source de courant (P1).

4. Cellule de bit de courant selon l'une quelconque des revendications 2 et 3, **caractérisée en ce que** la source de courant se compose d'un transistor (P1) dont le drain est connecté aux sources d'un premier et d'un second transistor (P2, P5) formant les moyens à transistor à effet de champ pour détecter l'état (L) de la cellule et aux sources d'un premier et d'un second transistor (P3, P4) formant les moyens à transistor à effet de champ pour détecter le complément (Lz) de l'état de ladite cellule.

5. Cellule de bit de courant selon la revendication 4, **caractérisée en ce que** la source du premier transistor (P2) pour détecter l'état (L) de la cellule est connectée à la source de courant (P1) et son drain à la source d'un transistor (P6) formant les moyens à transistor à effet de champ pour détecter la présence d'un bit de signal numérique (Bit), alors que la source du premier transistor (P3) pour détecter le complément (Lz) de l'état de la cellule est connectée à la source de courant (P1) et son drain à la source d'un transistor (P7) formant les moyens à transistor à effet de champ pour détecter l'état (Lc) de la rangée de cellules à laquelle ladite cellule appartient, les drains desdits transistors (P6, P7) pour détecter la présence d'un bit de signal numérique et pour détecter l'état (Lc) de la rangée à laquelle la cellule appartient étant connectés à la premier sortie (S1), ledit premier transistor (P2) pour détecter l'état (L) de la cellule, le premier transistor (P3) pour détecter le complément (Lz) de l'état de la cellule, ledit transistor (P6) pour détecter la présence d'un bit de signal numérique (Bit) et ledit transistor (P7) pour détecter l'état (Lc) de la rangée de cellules à laquelle ladite cellule appartient formant lesdits premiers moyens à transistor à effet de champ pour commander l'apparition d'un courant sur la première sortie (S1).

6. Cellule de bit de courant selon les revendications 4 et 5, **caractérisée en ce que** la source du second transistor (P5) pour détecter l'état (L) de la cellule est connectée à la source de courant (P1) et son drain à la source d'un transistor (P9) formant les moyens à transistor à effet de champ pour détecter la présence du complément (Bitz) du bit de signal numérique, alors que la source du second transistor (P4) pour détecter le complément (Lz) de l'état de la cellule est connectée à la source de courant (P1) et son drain à la source d'un transistor (P8) formant les moyens à transistor à effet de champ pour détecter le complément (Lcz) de l'état de la rangée de cellules à laquelle ladite cellule appartient, les drains desdits transistors (P8, P9) pour détecter la présence du complément (Bitz) du bit de signal numérique et pour détecter le complément (Lcz) de l'état de la rangée à laquelle la cellule appartient étant connectés à la seconde sortie (S2), ledit second transistor (P4) pour détecter le complément (Lz) de l'état de la cellule, ledit second transistor (P5) pour détecter l'état (L) de la cellule, ledit transistor (P9) pour détecter la présence du bit complémentaire (Bitz) et ledit transistor (P8) pour détecter le complément (Lcz) de l'état de la rangée de cellules à laquelle ladite cellule appartient formant lesdits seconds moyens à transistor à effet de champ pour commander l'apparition d'un courant sur la seconde sortie (S2).

7. Cellule de bit de courant selon l'une quelconque des revendications 2 et 3, caracténsée en ce que la source de courant est formée d'un transistor (P1) dont le drain est connecté aux sources d'un transistor (P6) formant les moyens à transistor à effet de champ pour détecter la présence d'un bit de signal numérique (Bit), d'un premier transistor (P4) pour détecter le signal complémentaire (Lz) de l'état de la cellule et d'un transistor (P9) formant les moyens à transistor à effet de champ pour détecter la présence du signal complémentaire (Bitz) du bit de signal numérique, un second transistor (P3), formant, avec le premier transistor (P4) pour détecter le signal complémentaire (Lz) de l'état de la cellule, les moyens à transistor à effet de champ pour détecter la présence du signal complémentaire (Lz) de l'état de la cellule, ayant son drain connecté au drain du transistor (P6) pour détecter la présence d'un bit de signal numérique (Bit) et sa source connectée au drain du transistor (P9) pour détecter la présence du signal complémentaire (Bitz), la source du transistor (P6) pour détecter la présence d'un bit de signal numérique étant connectée à la source de courant (P1) et son drain à la source d'un premier transistor (P2) pour détecter l'état (L) de la cellule, la source du premier transistor (P4) pour détecter le signal complémentaire (Lz) de l'état de la cellule étant connectée à la source de courant (P1) et son drain à la source d'un transistor (P7) pour détecter l'état (Lc) de la rangée de cellules à laquelle ladite cellule appartient et avec la source d'un transistor (P8) formant les moyens à transistor à effet de champ pour détecter le signal complémentaire (Lcz) de l'état de ladite rangée de cellules, la source du transistor (P9) pour détecter le signal complémentaire (Bitz) du bit de signal numérique étant connectée à la source de courant (P1) et son drain à la source d'un second transistor (P5) formant, avec le premier transistor (P2) pour détecter l'état (L) de la cellule, les moyens à transistor à effet de champ pour détecter l'état (L) de la cellule, les drains des premier et second transistors (P2, P5) pour détecter l'état (L) de la cellule étant respectivement connectés au drain du transistor (P7) pour détecter l'état (Lc) de la rangée de cellules et au drain du transistor (P8) pour détecter le signal complémentaire (Lcz) de l'état de la rangée de cellules aux première et seconde sorties (S1, S2) de la cellule, ledit transistor (P6) pour détecter la présence d'un bit de signal numérique (Bit), ledit premier transistor (P4) pour détecter le signal complémentaire (Lz) de l'état de la cellule, ledit premier transistor (P2) pour détecter l'état (L) de la cellule et ledit transistor (P7) pour détecter l'état (Lc) de la rangée de cellules à laquelle ladite cellule appartient formant lesdits premiers moyens pour commander l'apparition d'un courant sur la premier sortie (S1), ledit transistor (P9) pour détecter la présence du signal complémentaire (Bitz) du bit de signal numérique, ledit premier transistor (P4) pour détecter le signal complémentaire (Lz) de l'état de la cellule, ledit second transistor (P5) pour détecter l'état (L) de la cellule et ledit transistor (P8) pour détecter le signal complémentaire (Lcz) de l'état de la rangée de cellules à laquelle ladite cellule appartient formant lesdits second moyens à transistor à effet de champ pour commander l'apparition d'un courant sur la seconde sortie (S2).

8. Réseau à courant commuté, **caractérisé en ce qu'**il est formé de cellules de bit de courant selon l'une quelconque des revendications 1 à 7, disposées en rangées et en colonnes, les première et seconde sorties desdites cellules étant respectivement connectées ensemble et **en ce que** lesdites cellules du réseau sont disposées autour du centre du réseau divisées en quatre quadrants d'une manière telle qu'elles sont commandées selon une séquence dans laquelle une commande d'une cellule située dans un quadrant est suivie par une commande d'une cellule située dans un quadrant symétrique au quadrant précédent, par rapport au centre du réseau.
